# EUROPEAN PATENT APPLICATION

(11) **EP 4 109 669 A1**
(43) Date of publication of application: **28.12.2022**
(21) Application number: 22170469.5
(22) Date of filing: 28.04.2022
(51) Int. Cl.: H01P 3/00, H01P 3/06, H01P 3/08, H01P 11/00

(54) **SIGNAL AND GROUND VIAS IN A GLASS CORE TO CONTROL IMPEDANCE**

(30) Priority: 23.06.2021 US 202117356023
(71) Applicant: Intel Corporation, Santa Clara, CA 95054 (US)
(72) Inventor: Kamgaing, Telesphor, Chandler, 85249 (US); Dogiamis, Georgios C., Chandler, 85226 (US); Prabhu Gaunkar, Neelam, Chandler, 85225 (US); Strong, Veronica, Hillsboro, 97123 (US); Aleksov, Aleksandar, Chandler, 85286 (US)
(74) Representative: Goddar, Heinz J.

(57) **Abstract**

Embodiments described herein may be related to apparatuses, processes, and techniques related to positioning signal and ground vias, or ground planes, in a glass core to control impedance within a package. Laser-assisted etching processes may be used to create vertical controlled impedance lines to enhance bandwidth and bandwidth density of high-speed signals on a package. Other embodiments may be described and/or claimed.

## Description

### FIELD

Embodiments of the present disclosure generally relate to the field of semiconductor packaging, and in particular to reducing impedance of signal lines.

### BACKGROUND

Continued growth in virtual machines and cloud computing will continue to increase the demand for high-speed I/O between semiconductor packages and other devices.

### BRIEF DESCRIPTION OF THE DRAWINGS

FIG. 1 illustrates multiple examples of laser-assisted etching of glass interconnects processes, in accordance with embodiments.
FIG. 2 illustrates a legacy cross-section and top-down view of a buildup layer that includes a signal via within an antipad surrounded by a plurality of ground vias.
FIG. 3 illustrates a buildup layer cross-section and top-down view of a buildup layer coupled with a glass core, that includes a signal via isolated from an antipad, and surrounded by a plurality of ground vias that are coupled with an antipad, in accordance with various embodiments.
FIG. 4 illustrates examples of a signal conductive structure surrounded by a ground conductive structure to control impedance of the signal line in a glass core, in accordance with various embodiments.
FIG. 5 illustrates examples of a signal trace and a reference ground within a glass core, in accordance with various embodiments.
FIGs. 6A-6B illustrate isometric views of examples of a signal trace and reference ground through a glass core, in accordance with various embodiments.
FIGs. 7A-7C illustrate various views of examples of stepped impedance surface layer transmission lines, in accordance with various embodiments.
FIG. 8 illustrates an example process for creating a buildup layer, in accordance with embodiments.
FIG. 9 schematically illustrates a computing device, in accordance with embodiments.

### DETAILED DESCRIPTION

Embodiments described herein may be related to apparatuses, processes, and techniques for positioning signal and ground vias or ground planes in a buildup layer or in a glass core to control impedance within a package. In embodiments, local antipads are removed around individual signal vias in the buildup layer of a package. The glass core of the package may be created using laser-assisted etching processes to create vertical controlled impedance lines to enhance bandwidth and bandwidth density of high-speed signals on the package.

Embodiments described herein may increase bandwidth density of the package, may increase frequency range of the package, for example operational frequency in the megahertz to greater than 100 GHz. In addition, embodiments as interconnects may also be used to support high-speed serialization deserialization (SerDes) interconnect systems, high-speed input-output (HSIO) interconnects such as but not limited to interfaces with PCIe (peripheral component interconnect express), DDR (Double Data Rate memory) and HBM (High bandwidth memory) systems.

One or more laser sources followed by wet-etching may be used to create through hole vias or trenches into the glass panel or glass wafer. Using these laser techniques, vias may be created with a small diameter, for example on the order of less than 10 µm, and may be spaced with a pitch on the order of 50 µm or less. Other vias may be created with different diameter sizes. These vias may be later plated and/or filled to create electrical pathways through the glass core. These techniques may be used to create vias in the glass wafer or panel that have high aspects ratios, for example 40:1 or 50:1. Because of the fine pitch of the vias, more signals may be routed through the glass core at a higher density and may expand the maximum frequency bandwidth supported by such via transition, resulting in higher bandwidth communications. In addition, these techniques may reduce or eliminate impedance mismatch, which in legacy implementations may limit the frequency bandwidth of signals transmitted through the package core and BGA interface.

In legacy implementations, transitions through the CCL core are improved by creating quasi-coaxial lines, whereby a signal plated through hole (PTH) is surrounded by multiple ground PTHs in the core and in the buildup layer. In legacy implementation, buildup layers may include antipads surrounding the signal PTH. Ground PTHs are typically in contact with the antipads. The size of the signal via and the distance between the signal via and the antipad edge will define the impedance of the via transition. This impedance is not well controlled as the location of the ground PTH is not accurately known. Additionally and in order to increase bandwidth density, legacy implementations may reduce the distance between the signal via and the antipad edge which results in a low impedance via transition due to increased parasitic capacitance. This impedance mismatch between the signal traces in the buildup layers and the via (PTH) transition has as a result that these legacy implementations incur frequency bandwidth limitations leading to low bandwidth interconnects. In legacy implementations, highfrequency operation of through package vias in the mm-Wave regime (30GHz - 300GHz) has been implemented using short or open stubs as matching elements. This technique works only for passband type of interconnect channels and cannot be extended to lowpass interconnect channels.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

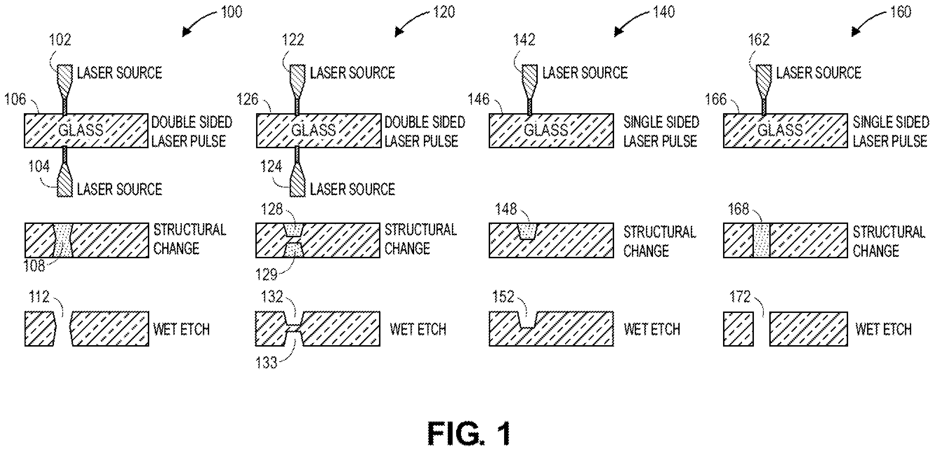

FIG. 1 illustrates multiple examples of laser-assisted etching of glass interconnects processes (which may be referred to as "LEGIT" herein), in accordance with embodiments. One use of the LEGIT technique is to provide an alternative substrate core material to the legacy copper clad laminate (CCL) core used in semiconductor packages used to implement products such as servers, graphics, clients, 5G, and the like. By using laser-assisted etching, crack free, high density via drills, hollow shapes may be formed into a glass substrate. In embodiments, different process parameters may be adjusted to achieve drills of various shapes and depths, thus opening the door for innovative devices, architectures, processes, and designs in glass. Embodiments, such as the bridge discussed herein, may also take advantage of these techniques.

Diagram 100 shows a high level process flow for a through via and blind via (or trench) in a microelectronic package substrate (e.g. glass) using LEGIT to create a through via or a blind via. A resulting volume/shape of glass with laser-induced morphology change that can then be selectively etched to create a trench, a through hole or a void that can be filled with conductive material. A through via 112 is created by laser pulses from two laser sources 102, 104 on opposite sides of a glass wafer 106. As used herein, a through drill and a through via refers to when the drill or the via starts on one side of the glass/substrate and ends on the other side. A blind drill and a blind via refers to when the drill or the via starts on the surface of the substrate and stops partially inside the substrate. In embodiments, the laser pulses from the two laser sources 102, 104 are applied perpendicularly to the glass wafer 106 to induce a morphological change 108, which may also be referred to as a structural change, in the glass that encounters the laser pulses. This morphological change 108 includes changes in the molecular structure of the glass to make it easier to etch out (remove a portion of the glass). In embodiments, a wet etch process may be used.

Diagram 120 shows a high level process flow for a double blind shape. A double blind shape 132, 133 may be created by laser pulses from two laser sources 122, 124, which may be similar to laser sources 102, 104, that are on opposite sides of the glass wafer 126, which may be similar to glass wafer 106. In this example, adjustments may be made in the laser pulse energy and/or the laser pulse exposure time from the two laser sources 122, 124. As a result, morphological changes 128, 129 in the glass 126 may result, with these changes making it easier to etch out portions of the glass. In embodiments, a wet etch process may be used.

Diagram 140 shows a high level process flow for a single-blind shape, which may also be referred to as a trench. In this example, a single laser source 142 delivers a laser pulse to the glass wafer 146 to create a morphological change 148 in the glass 146. As described above, these morphological changes make it easier to etch out a portion of the glass 152. In embodiments, a wet etch process may be used.

Diagram 160 shows a high level process flow for a through via shape. In this example, a single laser source 162 applies a laser pulse to the glass 166 to create a morphological change 168 in the glass 166, with the change making it easier to etch out a portion of the glass 172. As shown here, the laser pulse energy and/or laser pulse exposure time from the laser source 162 has been adjusted to create an etched out portion 172 that extends entirely through the glass 166.

With respect to FIG. 1, although embodiments show laser sources 102, 104, 122, 124, 142, 162 as perpendicular to a surface of the glass 106, 126, 146, 166, in embodiments, the laser sources may be positioned at an angle to the surface of the glass, with pulse energy and/or pulse exposure time variations in order to cause a diagonal via or a trench, or to shape the via, such as 112, 172, for example to make it cylindrical, tapered, or include some other feature. In addition, varying the glass type may also cause different features within a via or a trench as the etching of glass is strongly dependent on the chemical composition of the glass.

In embodiments using the process described with respect to FIG. 1, through hole vias 112, 172 may be created that are less than 10 µm in diameter, and may have an aspect ratio of 40:1 to 50:1. As a result, a far higher density of vias may be placed within the glass and be placed closer to each other at a fine pitch. In embodiments, this pitch may be 50 µm or less. After creating the vias or trenches, a metallization process may be applied in order to create a conductive pathway through the vias or trenches, for example a plated through hole (PTH). Using these techniques, finer pitch vias will result in better signaling, allowing more I/O signals to be put through the glass wafer and to other coupled components such as a substrate.

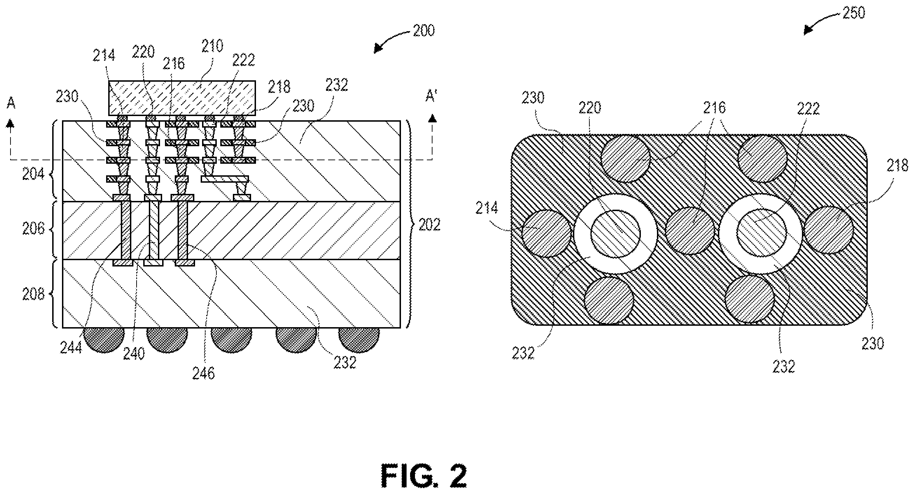

FIG. 2 illustrates a legacy cross-section and top-down view of a buildup layer that includes a signal via within an antipad surrounded by a plurality of ground vias. Diagram 200 shows a side view cross-section of a legacy substrate 202 that includes a top buildup layer 204, a copper clad laminate (CCL) 206 core, and a bottom buildup layer 208. A die 210 is coupled to a top surface of the top buildup layer 204. The top buildup layer 204 and the bottom buildup layer 208 may include a dielectric 232 within the buildup layers.

In implementations, the first buildup layer 204 may have multiple PTH including ground PTH 214, 216, 218, and signal PTH 220, 222. In embodiments, the ground PTH 214, 216, 218 are surrounded by one or more antipad layers 230. In embodiments, an antipad layer 230 exists within a layer of a substrate between a PTH and other copper structures such as traces or planes to maintain correct impedance in transmission lines, for example PTH 220, 222 serving as the return ground plane.

Diagram 250 shows a top-down cross-section at A-A' that includes signal PTH 220, 222 surrounded by dielectric 232. This is all surrounded with extended antipads 230 that are coupled with and surround the ground PTH 214, 216, 218. Note that the positioning of the ground PTH 214, 216, 218 form a quasi-coaxial structure to facilitate signal transmission through the signal PTH 220, 222. The size of the void between the signal via pad and the antipad is very critical as it influences the impedance of the via transition. Smaller voids would result in higher capacitance and hence a lower overall impedance. Turning back to diagram 200, ground PTH 244, 246 that electrically couple with the ground PTH 214, 216 of the buildup layers 204, and signal PTH 240 that electrically couples with the ground PTH 220, are located within the CCL core 206. In implementations, the ground PTH 244, 246, in addition to other ground PTH (not shown), together with the signal PTH 240, may form a quasi-coaxial structure within the CCL core 206. In implementations, the via pad is substantially of larger diameter than the via diameter through the CCL core. This limits the minimum pitch that signal PTH 240 and ground PTH 244 and 246 can be placed and in consequence reduces the overall achievable bandwidth density through the CCL core. Additionally, such large pitch leads to unwanted resonances at the via transition further limiting the usable bandwidth. To overcome this bandwidth density reduction, legacy implementations may space the signal and ground vias closer together by reducing the void between the signal via pad edge and the antipad edge. This results in turn to higher parasitic capacitance at the signal PTH 240 lowering the via transition impedance. This manifests as an impedance mismatch between the signal PTH 240 and other signal traces within the buildup layers 204, 208. Such impedance mismatch causes bandwidth reduction and hence limits the maximum achievable bandwidth density.

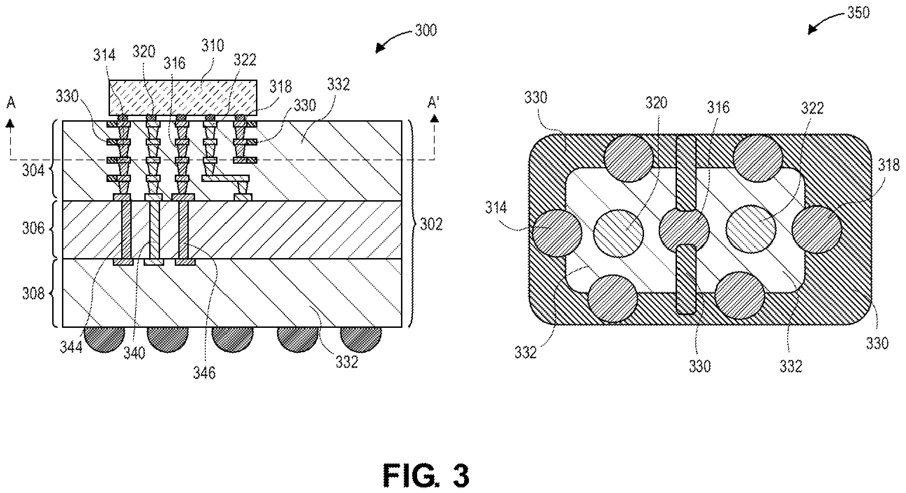

FIG. 3 illustrates a buildup layer cross-section and top-down view of a buildup layer coupled with a glass core, that includes a signal via isolated from an antipad, and surrounded by a plurality of ground vias that are coupled with an antipad, in accordance with various embodiments.

Diagram 300, which may be similar to diagram 200, shows a side view cross-section of a legacy substrate 302 that includes a top buildup layer 304, a glass core 306 core, and a bottom buildup layer 308. A die 310 is coupled to a top surface of the top buildup layer 304. The top buildup layer 304 and the bottom buildup layer 308 may include a dielectric 332 within the buildup layers.

In embodiments, the first buildup layer 304 may have multiple PTH including ground PTH 314, 316, 318, and signal PTH 320, 322. In embodiments, the ground PTH 314, 316, 318, are in at least partial contact with one or more antipad layers 330. In embodiments, an antipad layer 330 exists within a layer of a substrate between a PTH and other copper structures such as traces or planes, to maintain correct impedance in transmission lines, for example in PTH 320, 322 while also serving as the return ground plane.

Diagram 350 shows a top-down cross-section at A-A' of an embodiment that includes signal PTH 320, 322 surrounded by dielectric 332. This may be surrounded with extended antipads 332 that are physically coupled with each of the ground PTH, including PTH grounds 314, 316, 318. Note that the positioning of the ground PTH 314, 316, 318 form a quasi-coaxial structure to facilitate signal transmission through the signal PTH 320, 322. Note that the center ground 316 is in physical contact with the antipad layer 330. This allows us to have full ground connection in each substrate build-up layer while minimizing the signal to ground parasitic capacitance, which is often times a limiting factor for the frequency bandwidth.

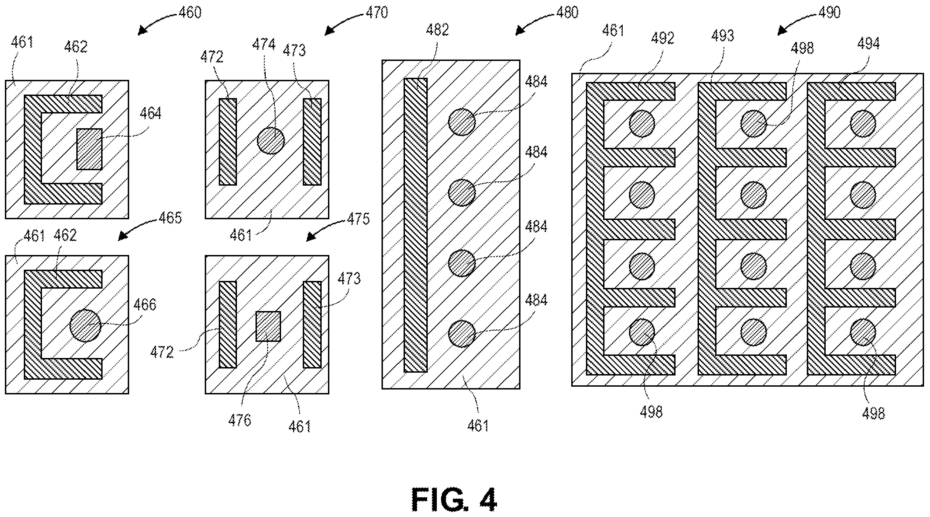

Turning back to diagram 300, ground conductive structures 344, 346 that electrically couple with the ground PTH 314, 316 of the buildup layers 304, and signal conductive structure 340 that electrically couples with the signal PTH 320, are located within the glass core 306. In some embodiments, the ground conductive structures 344, 346 may be implemented as through glass vias, in addition to other ground conductive structures (not shown), together with the signal conductive structure 340, may form a quasi-coaxial structure within the CCL core 306. In embodiments, the ground conductive structures 344, 346 and the signal conductive structures 340 may take a form other than a through via, as discussed further below with respect to FIG. 4.

FIG. 4 illustrates examples of a signal conductive structure surrounded by a ground conductive structure to control impedance of the signal line in a glass core, in accordance with various embodiments. Note that the examples of FIG. 4 are top-down views where antipads have been omitted for clarity. As discussed above with respect to FIG. 3, the examples 460, 465, 470, 475, 480, 490 are non-limiting examples of cross-sections of various signal and ground conductive structures that may be constructed using the processes and techniques described herein, and in particular with respect to FIG. 1. In embodiments, these conductive structures may be arrayed to enable signal buses with high isolation or low cross talk through the glass core. In embodiments, the ability to create vias and planes of arbitrary shapes with highly scaled dimensions and pitches within the glass core is providing accurate impedance control compared to legacy implementations, increasing in parallel the maximum bandwidth of operation of such core transitions and the overall bandwidth density through the core.

Example 460 and example 465 are examples of a coplanar waveguide. In example 460, a ground conductive structure 462 partially surrounds a signal conductive structure 464 within a glass core 461. In embodiments, the ground conductive structure 462 may fully surround three sides of the signal conductive structure 464. In other embodiments, the ground conductive structure 462 may only partially surround the signal conductive structure 464. In embodiments, the signal conductive structure 464 may have a rectangular cross-section. In other embodiments (not shown), the signal conductive structure may have a polygonal cross-section. Example 465 is another example of a coplanar waveguide, which may be similar to example 460, where the signal conductive structure 466 may have a circular cross-section, and may be manufactured similar to a plated or a filled through glass via as described above with respect to FIG. 1.

Example 470 and example 475 are examples of a strip line structure. An example 470, ground conductive structures 472, 473 are positioned on either side of a signal conductive structure 474 within the glass core 461. As shown, the signal conductive structure 474 may have a circular cross-section, as shown. Example 475 shows an example similar to example 470, however the signal conductive structure 476 has a square cross-section, as shown. In other embodiments, the signal conductive structure 476 may have a polygonal cross-section (not shown).

Example 480 shows an example of a microstrip, with a ground conductive structure 482 on one side of a plurality of signal conductive structures 484 within a glass core 461. As shown, the signal conductive structures 484 may have a circular cross section. However, in other embodiments, signal conductive structures may have a polygonal cross section, or some other cross-section profile (not shown).

Example 490 shows an example of an array of controlled impedance lines within a glass core 461. As shown, a plurality of ground conductive structures 492, 493, 494 partially surround a plurality of signal conductive structures 498. A plurality of conductive structures 498 are arrayed to enable signal buses with high bandwidth density, high isolation or low cross talk through the glass core. It should be appreciated that examples 460, 466, 470, 475, 480, and 490 are example embodiments with various ground conductive structures and signal conductive structures that may have their depth, thickness, material composition, dimensions of separation, geometry, and other attributes varied in order to achieve a particular impedance value or shielding value desired for a package.

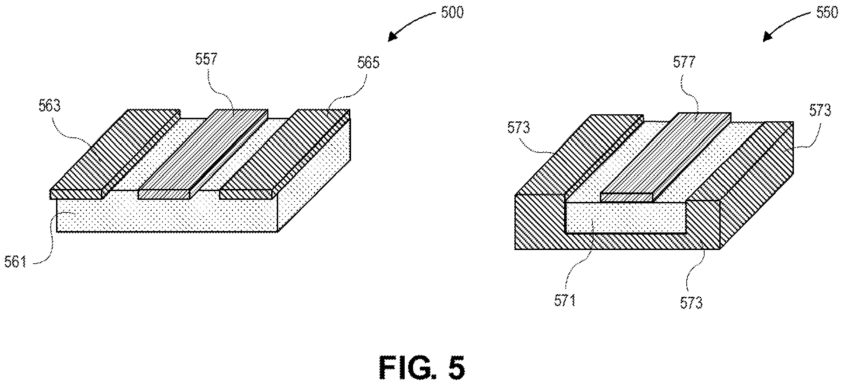

FIG. 5 illustrates examples of a signal trace and a reference ground within a glass core, in accordance with various embodiments. Note that although the image of FIG. 5 is drawn in a planar configuration, the planes and signal trace is described below may go through the glass core. Substrate 500 shows a glass core 561, onto which a signal trace 557 is deposited. As shown, to separate reference grounds 563, 565 are placed on the same surface of the glass core 561 as the signal trace 557. In embodiments, the reference grounds 563, 565 provide shielding for the signal trace 557. Substrate 550 shows a reference ground 573 that wraps around the sides in the bottom of a glass core 571, to provide reference grounding for both sides of a signal trace 577 that is applied to the top surface of the glass core 571.

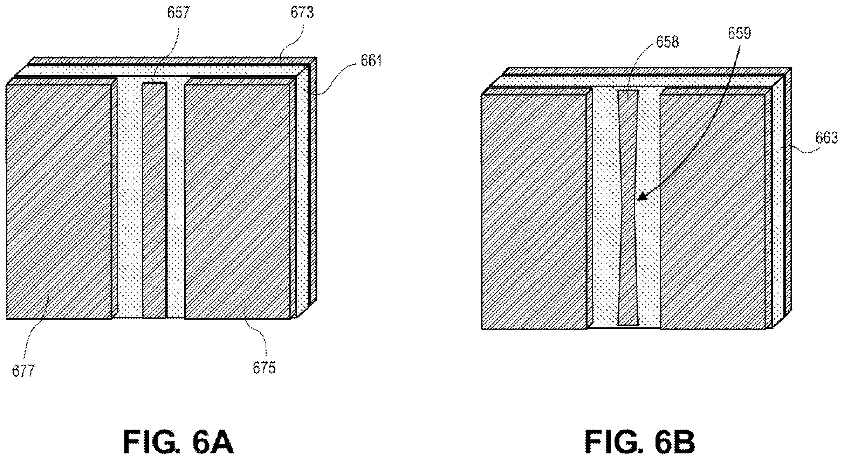

FIGs. 6A-6B illustrate isometric views of examples of a signal trace and reference ground through a glass core, in accordance with various embodiments. FIG. 6A shows an example of a substrate that has a glass core 661, with a reference ground plane 673 on the back side of the glass core 661, and to reference ground planes 675, 677 on the front side of the glass core 661. A vertical signal transmission line 657 is positioned on the front side of the glass core 661 in between the reference ground plane 675, 677.

By surrounding the vertical signal transmission line 657 on three sides with reference ground planes 673, 675, 677, this provides the vertical signal transmission line 657 with a high degree of EMI isolation and impedance control. Note that in embodiments, the reference ground planes 673, 675 677 and the vertical signal transmission line 657 may be etched into a portion of the glass substrate 661 using the techniques described herein with respect to FIG. 1.

FIG. 6B is similar to FIG. 6A, except that the vertical signal transmission line 658, which may be similar to the vertical signal transmission line 657 of FIG. 6A, may be partially tapered to the location 659 of the vertical signal transmission line 658 on the glass substrate 663, which may be similar to glass substrate 661 of FIG. 6A. In embodiments, this taper may be due to the techniques described above with respect to FIG. 1.

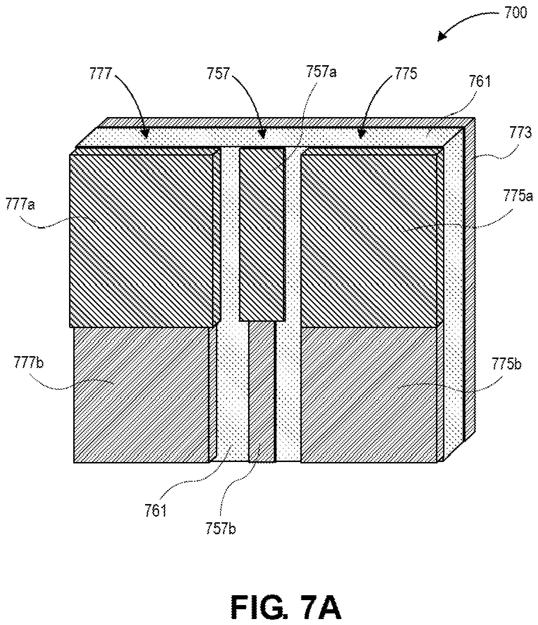

FIGs. 7A-7C illustrate various views of examples of stepped impedance surface layer transmission lines, in accordance with various embodiments. These transmission lines can also be implemented as strip lines. FIG. 7A shows a stepped impedance coplanar waveguide with ground (CPWG) transmission line that may be created by two separate drill processes, using the techniques described above with respect to FIG. 1. Substrate 700 has a glass core 761 that has a reference ground plane 773 on the backside of the glass core 761. On the front side of the glass core 761, there is a vertical transmission line 757 that is made up of a first trace 757a with a first trace thickness and a second trace 757b with a second trace thickness. Note that the ground planes 775a, 775b and 773 can also be connected to one another through the thickness of the core to ensure a continuous return path for the current.

On one side of the vertical transmission line 757 there is a reference ground plane 775 that has a first trace 775a with a first thickness and a second trace 775b with a second thickness. On the other side of the vertical transmission line 757, there is another reference ground plane 777 that has a first trace 777a with the first thickness and a second trace 777b with the second thickness.

In embodiments, the different thicknesses may be achieved by two separate drill processing using the techniques of FIG. 1. The process may include drilling from the top side of the glass core 761 to create reference ground planes 775a, 777a and vertical transmission line 757a. The process may further include drilling from the bottom side of the glass core 761 to create reference ground planes 775b, 777b and vertical transmission line 757b. In embodiments, dimensions of the thicknesses of the reference ground planes 775, 777 and of the vertical transmission line 757 may be chosen to achieve variable impedances along the length of the transmission line during operation of the substrate 700. Stepped impedance transmission lines are useful impedance matching techniques especially for mm-Wave (30GHz-300GHz) interconnect channels.

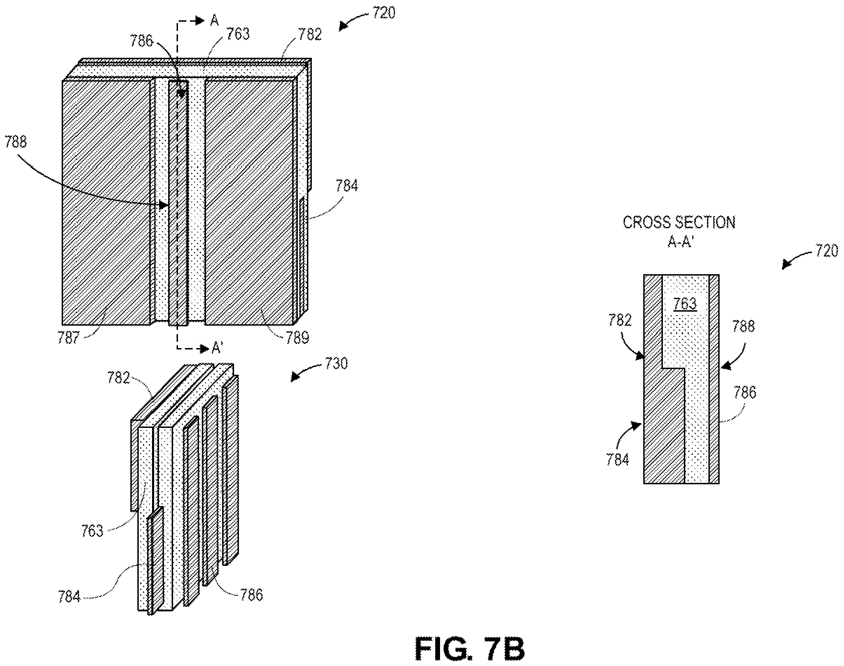

FIG. 7B shows another embodiment of the stepped impedance CPWG transmission line on the package that may be similar to FIG. 7A. The glass core 763, which may be similar to glass core 761 of FIG. 7A, has a reference ground plane 782 on a backside of the glass core 763, that extends only partially down the backside of the glass core 763. Another reference ground plane 784 may be inserted within the center of the glass core 763 or any intermediary location between ground plane 787 and reference ground plane 782, using techniques described above with respect to FIG. 1. Ground planes 787, 789 may be attached with the front surface of the glass core 763, with the vertical transmission line 786 positioned between the ground plane 787, 789. At location 788 within the vertical transmission line 786, there may be an impedance change within the vertical transmission line 786 corresponding to the separation distance of the other reference ground plane 784 in the center of the glass core 763 from the vertical transmission line 786. Diagram 730 shows an alternative perspective view of substrate 720. Note that the two reference GND planes 784, 782, 787 and 789 will all be connected to one another to ensure continuous return paths for the current.

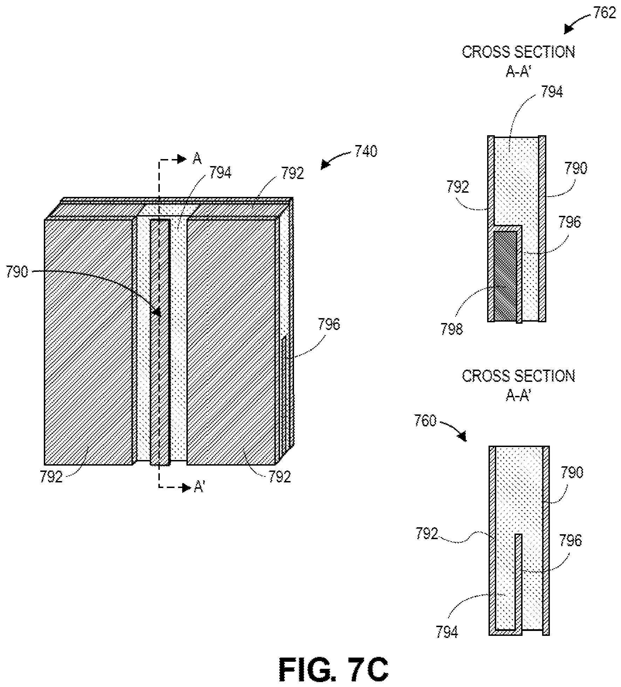

FIG. 7C shows another embodiment of the stepped impedance package that may be similar to FIG. 7A and FIG. 7B. Substrate 740 shows a first ground plane 792 extends from the back of a glass core 794 to the front of the glass core 794, and wraps around a vertical transmission line 790 that is surrounded by the glass core 794. In embodiments, the first ground plane 792 may be similar to the ground plane 573 of FIG. 5. A lower portion of the 740 has a second reference ground plane 796 at an intermediate depth in the glass core. This ground plane 796 also wraps around the vertical transmission line 790 and also connects to the reference ground plane 792 as seen in Diagram 760. In diagram 762, region 798 may be a dielectric fill or a metal fill.

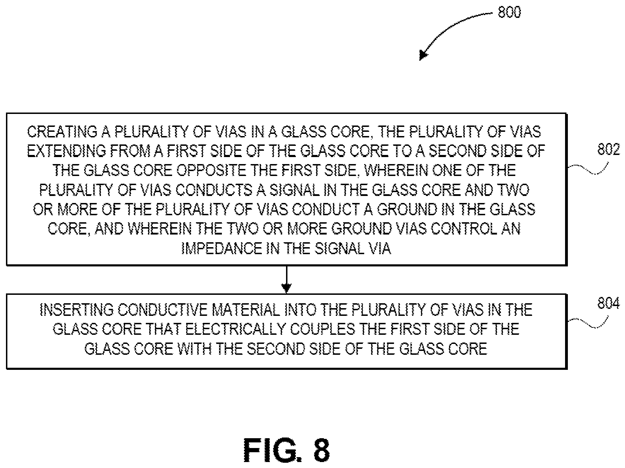

FIG. 8 illustrates an example process for creating a buildup layer, in accordance with various embodiments. Process 800 may be performed by one or more of the techniques, apparatus, processes, or systems described with respect to FIGs. 1-7C.

At block 802, the process may include creating a plurality of vias in a glass core, the plurality of vias extending from a first side of the glass core to a second side of the glass core opposite the first side, wherein one of the plurality of vias conducts a signal in the glass core and one or more of the plurality of vias conduct a ground in the glass core, and wherein the two or more ground vias control an impedance in the signal via. In embodiments, the glass core may be similar to glass core 106, 126, 146, 166 of FIG. 1, glass core 306 of FIG. 3 or glass core 461 of FIG. 4. In embodiments, the plurality of vias may be similar to vias 344, 340, 346 of FIG. 3. In embodiments, creating a plurality of vias in the glass core may be performed using the techniques described with respect to FIG. 1 above.

At block 804, the process may further include inserting conductive material into the plurality of vias in the glass core that electrically couples the first side of the glass core with the second side of the glass core. in embodiments, the conductive material may be similar to conductive material in conductive structure 462, 464, 466 of FIG. 4.

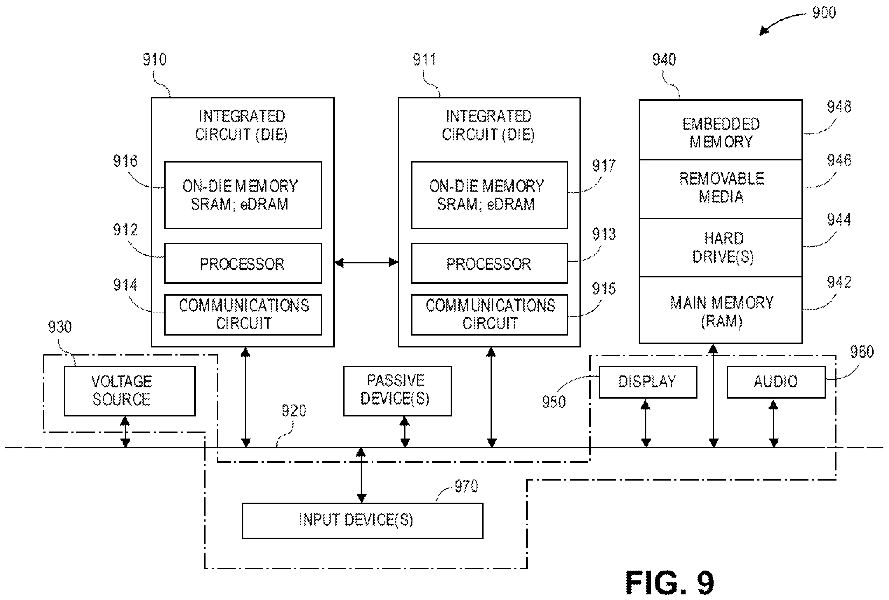

FIG. 9 schematically illustrates a computing device, in accordance with various embodiments. The computer system 900 (also referred to as the electronic system 900) as depicted can embody all or part of signal and ground vias in a glass core to control impedance, according to any of the several disclosed embodiments and their equivalents as set forth in this disclosure. The computer system 900 may be a mobile device such as a netbook computer. The computer system 900 may be a mobile device such as a wireless smart phone. The computer system 900 may be a desktop computer. The computer system 900 may be a hand-held reader. The computer system 900 may be a server system. The computer system 900 may be a supercomputer or high-performance computing system.

In an embodiment, the electronic system 900 is a computer system that includes a system bus 920 to electrically couple the various components of the electronic system 900. The system bus 920 is a single bus or any combination of busses according to various embodiments. The electronic system 900 includes a voltage source 930 that provides power to the integrated circuit 910. In some embodiments, the voltage source 930 supplies current to the integrated circuit 910 through the system bus 920.

The integrated circuit 910 is electrically coupled to the system bus 920 and includes any circuit, or combination of circuits according to an embodiment. In an embodiment, the integrated circuit 910 includes a processor 912 that can be of any type. As used herein, the processor 912 may mean any type of circuit such as, but not limited to, a microprocessor, a microcontroller, a graphics processor, a digital signal processor, or another processor. In an embodiment, the processor 912 includes, or is coupled with, all or part of signal and ground vias in a glass core to control impedance, as disclosed herein. In an embodiment, SRAM embodiments are found in memory caches of the processor. Other types of circuits that can be included in the integrated circuit 910 are a custom circuit or an application-specific integrated circuit (ASIC), such as a communications circuit 914 for use in wireless devices such as cellular telephones, smart phones, pagers, portable computers, two-way radios, and similar electronic systems, or a communications circuit for servers. In an embodiment, the integrated circuit 910 includes on-die memory 916 such as static random-access memory (SRAM). In an embodiment, the integrated circuit 910 includes embedded on-die memory 916 such as embedded dynamic random-access memory (eDRAM).

In an embodiment, the integrated circuit 910 is complemented with a subsequent integrated circuit 911. Useful embodiments include a dual processor 913 and a dual communications circuit 915 and dual on-die memory 917 such as SRAM. In an embodiment, the dual integrated circuit 910 includes embedded on-die memory 917 such as eDRAM.

In an embodiment, the electronic system 900 also includes an external memory 940 that in turn may include one or more memory elements suitable to the particular application, such as a main memory 942 in the form of RAM, one or more hard drives 944, and/or one or more drives that handle removable media 946, such as diskettes, compact disks (CDs), digital variable disks (DVDs), flash memory drives, and other removable media known in the art. The external memory 940 may also be embedded memory 948 such as the first die in a die stack, according to an embodiment.

In an embodiment, the electronic system 900 also includes a display device 950, an audio output 960. In an embodiment, the electronic system 900 includes an input device such as a controller 970 that may be a keyboard, mouse, trackball, game controller, microphone, voice-recognition device, or any other input device that inputs information into the electronic system 900. In an embodiment, an input device 970 is a camera. In an embodiment, an input device 970 is a digital sound recorder. In an embodiment, an input device 970 is a camera and a digital sound recorder.

As shown herein, the integrated circuit 910 can be implemented in a number of different embodiments, including all or part of signal and ground vias in a glass core to control impedance, according to any of the several disclosed embodiments and their equivalents, an electronic system, a computer system, one or more methods of fabricating an integrated circuit, and one or more methods of fabricating an electronic assembly that includes a package substrate implementing all or part of signal and ground vias in a glass core to control impedance, according to any of the several disclosed embodiments as set forth herein in the various embodiments and their art-recognized equivalents. The elements, materials, geometries, dimensions, and sequence of operations can all be varied to suit particular I/O coupling requirements including array contact count, array contact configuration for a microelectronic die embedded in a processor mounting substrate according to any of the several disclosed processes used for signal and ground vias in a glass core to control impedance embodiments and their equivalents. A foundation substrate may be included, as represented by the dashed line of FIG. 9. Passive devices may also be included, as is also depicted in FIG. 9.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments.

### EXAMPLES

Example 1 is a package, comprising: a glass core having a first side and a second side opposite the first side; a plurality of conductive structures extending through the glass core from the first side to the second side; wherein one of the conductive structures carries a signal and another of the conductive structures carries a ground, wherein the conductive structure that carries the ground controls an impedance of the conductive structure that carries a signal.

Example 2 includes the package of example 1, wherein the conductive structure that carries the signal is a conductive via.

Example 3 includes the package of example 2, wherein the conductive via is a selected one of: conformally plated or filled.

Example 4 includes the package of example 2, wherein a shape of the conductive structure that carries the signal is a selected one of: a circle, a rectangle, a polygon, or an irregular shape.

Example 5 includes the package of example 1, wherein the conductive structure that carries the ground is located on three sides of the conductive structure that carries the signal.

Example 6 includes the package of example 1, further comprising another conductive structure that carries the ground; and wherein the conductive structure that carries the ground and the other conductive structure that carries the ground are on opposite sides of the conductive structure that carries the signal.

Example 7 includes the package of any one of examples 1-6, further comprising another conductive structure that carries the signal; and wherein the conductive structure that carries the ground at least partially surrounds the conductive structure that carries the signal and the other conductive structure that carries the signal.

Example 8 includes the package of any one of examples 1-6, wherein the conductive structure that carries the ground includes a selected one of: a strip line or a microstrip.

Example 9 includes the package of any one of examples 1-6, wherein the conductive structures include copper.

Example 10 is a package comprising: a buildup layer comprising: a plurality of conductive vias extending through the buildup layer from the first side of the buildup layer to a second side of the buildup layer opposite the first side; wherein one of the conductive vias carries a signal and another plurality of the conductive vias that carry a ground, wherein the other plurality of conductive vias that carry the ground surround the conductive via that carries the signal and controls an impedance of the conductive via that carries the signal.

Example 11 includes the package of example 10, wherein the other plurality of the conductive vias that carry the ground are coupled with an antipad.

Example 12 includes the package of example 11, wherein the antipad is not concentric around the conductive vias.

Example 13 includes the package of example 10, wherein the conductive via that carries the signal is a first conductive via the carries a first signal; and further comprising a second conductive via that carries a second signal, the first conductive via and the second conductive via separated by one of the conductive vias that carry the ground, wherein the second conductive via is isolated from the antipad.

Example 14 includes the package of any one of examples 10-13, further comprising: a glass core comprising: a first side and a second side opposite the first side; a plurality of conductive structures extending through the glass core from the first side to the second side; wherein one of the conductive structures carries a signal and another of the conductive structures carries a ground, wherein the conductive structure that carries the ground controls an impedance of the conductive structure that carries a signal; and wherein a second side of the buildup layer is coupled with the first side of the glass core.

Example 15 includes the package of example 14, wherein one of the conductive structures of the glass core that carries the signal is electrically coupled with one of the conductive vias of the buildup layer that carries the signal, and wherein one of the conductive structures of the glass core that carries the ground is electrically coupled with one of the conductive vias of the buildup layer that carries the ground.

Example 16 includes the package of example 14, wherein a shape of the conductive structure that carries the signal in the glass core is a selected one of: a circle, a rectangle, a polygon, or an irregular shape.

Example 17 includes the package of example 14, wherein the conductive structure that carries the ground is located on at least two sides of the conductive structure that carries the signal.

Example 18 is a method comprising: creating a plurality of vias in a glass core, the plurality of vias extending from a first side of the glass core to a second side of the glass core opposite the first side, wherein one of the plurality of vias conducts a signal in the glass core and one or more of the plurality of vias conduct a ground in the glass core, and wherein the two or more ground vias control an impedance in the signal via; and inserting conductive material into the plurality of vias in the glass core that electrically couples the first side of the glass core with the second side of the glass core.

Example 19 includes the method of example 18, further comprising: forming a buildup layer on the first side of the glass core, the buildup layer comprising: a plurality of conductive vias extending through the buildup layer from the first side of the buildup layer to a second side of the buildup layer opposite the first side, the second side of the buildup layer coupled with the first side of the glass core; wherein one of the conductive vias carries a signal and another plurality of the conductive vias carry a ground, wherein the other plurality of conductive vias that carry the ground surround the conductive via that carries the signal and controls an impedance of the conductive via that carries the signal; and wherein the conductive via of the buildup layer carrying the signal is electrically coupled with the conductive via carrying the signal in the glass core, and wherein the conductive via of the buildup layer carrying the ground is electrically coupled with the conductive vias carrying the ground in the glass core.

Example 20 includes the method of example 19, wherein forming a buildup layer further includes forming a buildup layer wherein the conductive vias in the buildup layer carrying the ground are coupled with an antipad; and wherein the conductive vias in the buildup layer carrying the signal are isolated from the antipad.

Example 21 includes the method of any one of examples 18-20, wherein the conductive via is a copper via.

Example 22 is an integrated circuit package, comprising: a glass core having a first side and a second side opposite the first side; a first conductive structure extending through the glass core from the first side to the second side; a second conductive structure adjacent to the first conductive structure, the second conductive structure extending through the glass core from the first side to the second side; wherein the first conductive structure has a circular cross section; wherein the second conductive structures has a non-circular cross section; and wherein the second structure conductive structure comprises a ground plane.

Example 23 includes the integrated circuit package of example 22, wherein the second conductive structure has one of a rectangular, a polygonal, or an irregular cross section.

Example 24 includes the integrated circuit package of example 22, further comprising a third conductive structure, wherein the first conductive structure is between the second conductive structure and the third conductive structure, wherein the third conductive structure has a non-circular cross section, and wherein the third conductive structure comprises a ground plane.

Example 25 includes a package, comprising: a glass core having a first side and a second side opposite the first side; a plurality of conductive structures extending through the glass core from the first side to the second side; wherein a first one of the conductive structures comprises a signal trace and a second one of the conductive structures comprises a ground reference, wherein the second one of the conductive structure controls an impedance of the first one of the conductive structures.

Example 26 includes the package of example 25, wherein the conductive structure that comprises the signal trace is a conductive via.

Example 27 includes the package of example 26, wherein the conductive via is a selected one of: conformally plated or filled.

Example 28 includes the package of example 26, wherein a shape of the conductive structure that comprises the signal trace is a selected one of: a circle, a rectangle, a polygon, or an irregular shape.

Example 29 includes the package of example 25, wherein the conductive structure that comprises the ground reference is located on three sides of the conductive structure that carries the signal.

Example 30 includes the package of example 25, further comprising another conductive structure that comprises the ground reference; and wherein the conductive structure that comprises the ground reference and the other conductive structure that comprises the ground reference are on opposite sides of the conductive structure that carries the signal.

Example 31 includes the package of example 25, further comprising another conductive structure that comprises a signal trace; and wherein the conductive structure that comprises the ground reference at least partially surrounds the conductive structure that comprises the signal trace and the other conductive structure that comprises the signal trace.

Example 32 includes the package of example 25 wherein the conductive structure that comprises the ground reference includes a selected one of: a strip line or a microstrip.

Example 33 includes the package of any one of examples 25-32, wherein the conductive structures include copper.

Example 34 is a package comprising: a buildup layer comprising: a plurality of conductive vias extending through the buildup layer from the first side of the buildup layer to a second side of the buildup layer opposite the first side; wherein one of the conductive vias comprises a signal trace and another plurality of the conductive vias comprise a ground reference, wherein the other plurality of conductive vias that comprise the ground reference surround the conductive via that comprise the signal trace and controls an impedance of the conductive via that comprise the signal trace.

Example 35 includes the package of example 34, wherein the other plurality of the conductive vias that comprise the ground reference are coupled with an antipad.

Example 36 includes the package of example 35, wherein the antipad is not concentric around the conductive vias.

Example 37 includes the package of example 34, wherein the conductive via that comprise the signal trace is a first conductive via the comprises a first signal trace; and further comprising a second conductive via that comprises a second signal trace, the first conductive via and the second conductive via separated by one of the conductive vias that comprise the ground reference, wherein the second conductive via is isolated from the antipad.

Example 38 includes the package of example 34, further comprising: a glass core comprising: a first side and a second side opposite the first side; a plurality of conductive structures extending through the glass core from the first side to the second side; wherein one of the conductive structures comprises a signal trace and another of the conductive structures comprises a ground reference, wherein the conductive structure that comprises the ground reference controls an impedance of the conductive structure that comprises the signal trace; and wherein a second side of the buildup layer is coupled with the first side of the glass core.

Example 39 includes the package of example 38, wherein one of the conductive structures of the glass core that comprises the signal trace is electrically coupled with one of the conductive vias of the buildup layer that comprises the signal trace, and wherein one of the conductive structures of the glass core that comprises the ground reference is electrically coupled with one of the conductive vias of the buildup layer that comprises the ground reference.

Example 40 includes the package of example 38, wherein a shape of the conductive structure that comprises a signal trace in the glass core is a selected one of: a circle, a rectangle, a polygon, or an irregular shape.

Example 41 includes the package of any one of examples 38-40, wherein the conductive structure that comprises the ground reference is located on at least two sides of the conductive structure that carries the signal.

## Claims

1. A package, comprising:
a glass core having a first side and a second side opposite the first side;
a plurality of conductive structures extending through the glass core from the first side to the second side;
wherein a first one of the conductive structures comprises a signal trace and a second one of the conductive structures comprises a ground reference, wherein the second one of the conductive structure controls an impedance of the first one of the conductive structures.

2. The package of claim 1, wherein the conductive structure that comprises the signal trace is a conductive via.

3. The package of claim 2, wherein the conductive via is a selected one of: conformally plated or filled.

4. The package of claim 2, wherein a shape of the conductive structure that comprises the signal trace is a selected one of: a circle, a rectangle, a polygon, or an irregular shape.

5. The package of claim 1, wherein the conductive structure that comprises the ground reference is located on three sides of the conductive structure that carries the signal.

6. The package of claim 1, further comprising another conductive structure that comprises the ground reference; and
wherein the conductive structure that comprises the ground reference and the other conductive structure that comprises the ground reference are on opposite sides of the conductive structure that carries the signal.

7. The package of claim 1, 2, 3, 4, 5 or 6, further comprising another conductive structure that comprises a signal trace; and
wherein the conductive structure that comprises the ground reference at least partially surrounds the conductive structure that comprises the signal trace and the other conductive structure that comprises the signal trace.

8. The package of claim 1, 2, 3, 4, 5 or 6, wherein the conductive structure that comprises the ground reference includes a selected one of: a strip line or a microstrip.

9. The package of claim 1, 2, 3, 4, 5 or 6, wherein the conductive structures include copper.

10. A method of fabricating a package, the method comprising:
providing a glass core having a first side and a second side opposite the first side;
forming a plurality of conductive structures extending through the glass core from the first side to the second side;
wherein a first one of the conductive structures comprises a signal trace and a second one of the conductive structures comprises a ground reference, wherein the second one of the conductive structure controls an impedance of the first one of the conductive structures.

11. The method of claim 10, wherein the conductive structure that comprises the signal trace is a conductive via.

12. The method of claim 11, wherein the conductive via is a selected one of: conformally plated or filled.

13. The method of claim 11, wherein a shape of the conductive structure that comprises the signal trace is a selected one of: a circle, a rectangle, a polygon, or an irregular shape.

14. The method of claim 10, wherein the conductive structure that comprises the ground reference is located on three sides of the conductive structure that carries the signal.

15. The method of claim 10, 11, 12, 13 or 14, wherein the conductive structures include copper.
